(19) Europäisches Patentamt
European Patent Office
Office européen des brevets

(11) **EP 3 913 418 B1**

(12) **FASCICULE DE BREVET EUROPEEN**

(45) Date de publication et mention
de la délivrance du brevet:
**27.03.2024 Bulletin 2024/13**

(21) Numéro de dépôt: **21174241.6**

(22) Date de dépôt: **18.05.2021**

(51) Classification Internationale des Brevets (IPC):
**G02B 26/08** (2006.01)    **G21K 1/06** (2006.01)
**G21K 7/00** (2006.01)    **G02B 21/02** (2006.01)
**G02B 21/04** (2006.01)    G02B 5/08 (2006.01)

(52) Classification Coopérative des Brevets (CPC):
**G02B 26/0825; G02B 21/025; G02B 21/04;
G21K 1/067;** G02B 5/0891; G21K 7/00

(54) **SYSTÈME OPTIQUE À DISTANCE FOCALE VARIABLE ET ENSEMBLE OPTIQUE COMPRENANT UN TEL SYSTÈME**

OPTISCHES SYSTEM MIT VARIABLER BRENNWEITE UND OPTISCHE ANORDNUNG MIT EINEM SOLCHEN SYSTEM

OPTICAL SYSTEM WITH VARIABLE FOCAL DISTANCE AND OPTICAL ASSEMBLY COMPRISING SUCH A SYSTEM

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **19.05.2020 FR 2005024**

(43) Date de publication de la demande:
**24.11.2021 Bulletin 2021/47**

(73) Titulaire: **THALES**
**92400 Courbevoie (FR)**

(72) Inventeurs:
• **PEVERINI, Luca**
**13852 AIX-EN-PROVENCE (FR)**
• **IMPERIALI, Stéphan**
**13852 AIX-EN-PROVENCE (FR)**
• **NEVIERE, Remy**
**13852 AIX-EN-PROVENCE (FR)**
• **DUFOUR, Thibault**
**13852 AIX-EN-PROVENCE (FR)**

(74) Mandataire: **Lavoix**
**2, place d'Estienne d'Orves**
**75441 Paris Cedex 09 (FR)**

(56) Documents cités:
WO-A1-2019/042809    FR-A- 1 049 576
US-A1- 2016 270 200

• **GOTO T ET AL: "Size-changeable x-ray beam collimation using an adaptive x-ray optical system based on four deformable mirrors", PROCEEDINGS OF SPIE; [PROCEEDINGS OF SPIE ISSN 0277-786X VOLUME 10524], SPIE, US, vol. 9965, 8 septembre 2016 (2016-09-08), pages 996502-996502, XP060080715, DOI: 10.1117/12.2238794 ISBN: 978-1-5106-1533-5**
• **KRISHNA P. KHAKUREL ET AL: "Generation of apodized X-ray illumination and its application to scanning and diffraction microscopy", JOURNAL OF SYNCHROTRON RADIATION, vol. 24, no. 1, 1 janvier 2017 (2017-01-01), pages 142-149, XP055520494, ISSN: 1600-5775, DOI: 10.1107/S1600577516017677**

## Description

La présente invention concerne un système optique à distance focale variable.

La présente invention concerne également un ensemble optique comprenant un tel système.

Le système optique selon l'invention est applicable dans de nombreux domaines techniques.

Parmi ces domaines, on peut notamment citer le domaine médical, le domaine de cristallographie, le domaine de spectroscopie, le domaine d'imagerie, etc.

Dans l'ensemble de ces domaines, le système optique selon l'invention peut être utilisé notamment en tant qu'une partie d'une installation plus complexe telle qu'un condenseur, un microscope, ou encore un télescope.

De manière générale, l'invention reste applicable dans toute installation où il est nécessaire de pointer de manière particulièrement précise un rayonnement.

Le rayonnement peut être de natures différentes.

En particulier, ce rayonnement électromagnétique peut être des rayons X, gamma ou ultraviolet extrême (appelés également rayons EUV).

De manière connue en soi, dans les applications précitées, on connait l'utilisation des systèmes optiques dans lesquels un rayonnement est dirigé vers une cible par un ensemble des miroirs selon des angles rasants.

Les angles rasants connus également sous le terme anglais de « grazing incidence », présentent généralement des angles inférieurs à quelques degrés, notamment inférieurs à 2° ou à 1°, permettent alors à l'ensemble des miroirs de concentrer le rayonnement correspondant sur une cible qui peut être mobile ou fixe.

Pour cela, l'état de la technique propose de nombreux systèmes optiques permettant d'assurer la précision souhaitée.

Parmi ces installations, on connait notamment le système de type KB (abréviation de Kirkpatrick-Baez) dans lequel deux miroirs sont disposés l'un après l'autre selon des angles différents sur une installation prévue à cet effet, pour envoyer le rayonnement vers le point de focus souhaité. Chaque miroir focalisant le faisceau dans une de ses dimensions.

Un système optique de type KB est notamment utilisable dans les microscopes fonctionnant avec des rayons à haute énergie (rayons X, EUV ou gamma).

Dans ce cas, les miroirs installés dans un tel système permettent de réfléchir et concentrer les rayons à haute énergie au point de focus après réflexion en incidence rasante.

Dans cette application, l'ajustement du point de focus permet d'effectuer la fonction de zoom d'un tel microscope.

On conçoit ainsi que la possibilité d'ajuster le point de focus dans un système de type KB présente un problème important.

Dans l'état de la technique, parmi les systèmes KB connus, on connait notamment des systèmes dans lesquels les miroirs présentent des courbures fixes qui peuvent être soit cylindriques, soit elliptiques, soit plats.

Toutefois, dans un tel cas, il n'est pas possible d'ajuster le point de focus de manière fine dans la direction de propagation du faisceau, l'unique possibilité d'ajustement restant la possibilité de déplacement physique des miroirs et/ou de la cible ce qui ne peut pas toujours être fait de manière précise.

Parmi d'autres systèmes KB, on connait également des systèmes dans lesquels les miroirs sont flexibles. Toutefois, ces miroirs ne définissent qu'une seule courbure dans laquelle le point de focus peut être atteint.

Cela demande alors une précision très élevée lors de la flexion de ces miroirs. De plus, il est nécessaire parfois de fléchir très significativement les miroirs ce qui peut conduire à leur rupture.

Parmi encore d'autres systèmes KB, on connait également des systèmes avec des miroirs présentant un nombre important d'actionneurs. Ces actionneurs peuvent être de nature mécanique ou électrique.

Toutefois, ce dernier système présente une très grande complexité avec de nombreux paramètres d'ajustement ce qui ne peut pas toujours être fait de manière aisée.

On connait également des systèmes optiques décrits dans les documents Goto T et al : « Size-changeable x-ray beam collimation using an adaptive x-ray optical system based on four deformable mirrors » et FR 1 049 576 A.

La présente invention a pour but de proposer un système optique à distance focale variable de structure très simple et permettant d'ajuster la distance focale dans une plage de distances focales prédéterminée.

À cet effet, l'invention a pour objet un système optique conforme à la revendication 1.

Selon d'autres aspects avantageux de l'invention, le système comprend une ou plusieurs des caractéristiques des revendications 2 à 11

La présente invention concerne également un ensemble optique tel que précédemment décrit et

- au moins deux miroirs interchangeables avec les miroirs dudit système optique pour modifier la plage de distances focales prédéterminées de ce système.

Ces caractéristiques et avantages de l'invention apparaitront à la lecture de la description qui va suivre, donnée uniquement à titre d'exemple et non limitatif, et faite en référence aux dessins annexés, sur lesquelles :

- [Fig 1] la figure 1 est une vue schématique en perspective d'un système optique selon un premier mode de réalisation de l'invention, le système optique comprenant notamment deux miroirs ;
- [Fig 2] la figure 2 est une vue de côté du système optique de la figure 1 ;

- [Fig 3] la figure 3 est une vue schématique en perspective et de côté de l'un des miroirs du système optique de la figure 1 ;
- [Fig 4] la figure 4 est une vue schématique d'un mécanisme de déformation utilisable pour fléchir le miroir de la figure 3 ;
- [Fig 5] la figure 5 est une vue schématique en perspective et de côté d'un miroir utilisable dans un système optique selon un deuxième mode de réalisation de l'invention ;
- [Fig 6] la figure 6 est une vue schématique d'un mécanisme de déformation permettant de fléchir le miroir de la figure 5 ;
- [Fig 7] la figure 7 est une vue schématique en perspective et de côté d'un miroir utilisable dans un système optique selon un troisième mode de réalisation de l'invention ;
- [Fig 8] la figure 8 est une vue schématique d'un mécanisme de déformation permettant de fléchir le miroir de la figure 7.

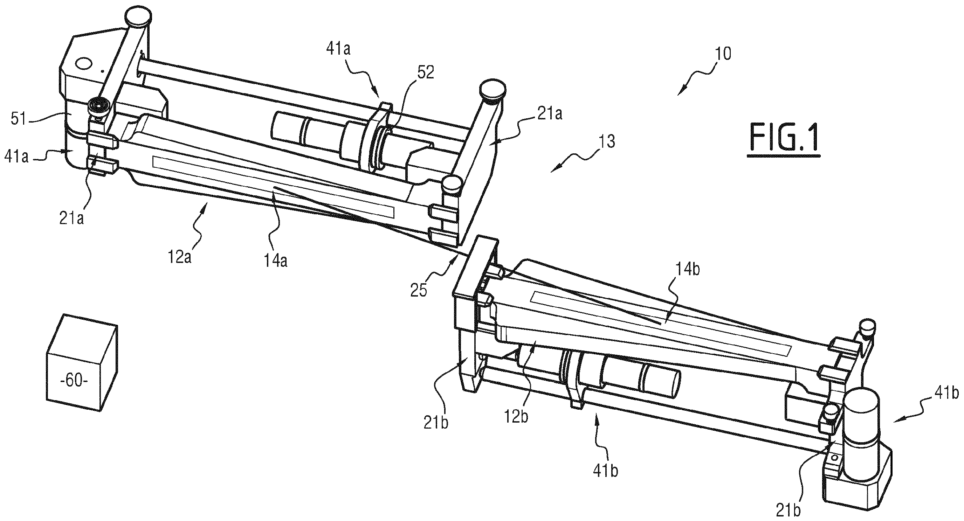

La figure 1 illustre en effet un système optique 10 selon un premier mode de réalisation de l'invention.

Ce système optique 10 permet de concentrer un rayonnement issu d'une source (non visible sur la figure 1) vers une cible (non visible sur la figure 1) disposée dans un plan focal de ce système.

De plus, selon l'invention, le système 10 permet d'ajuster la distance focale jusqu'à la cible, comme cela sera expliqué par la suite.

Par rayonnement, on entend tout rayonnement électromagnétique de tout spectre dépendant de la nature d'application du système optique 10.

À titre d'exemple, dans la suite de la description, ce rayonnement sera considéré en tant qu'un rayonnement des rayons X.

Toutefois, l'invention reste applicable à d'autres types de rayonnement, notamment à un rayonnement lumineux, un rayonnement gamma ou un rayonnement ultraviolet extrême.

Comme cela est visible sur la figure 1, le système optique 10 selon l'invention comprend deux miroirs 12a et 12b nommés ci-après respectivement premier miroir 12a et deuxième miroir 12b, ainsi qu'une installation mécanique KB 13.

Chacun des miroirs 12a, 12b présente une surface réfléchissante respectivement 14a, 14b adaptée pour réfléchir le rayonnement correspondant.

L'installation KB 13, appelée également installation de type Kirkpatrick-Baez, est connue en soit.

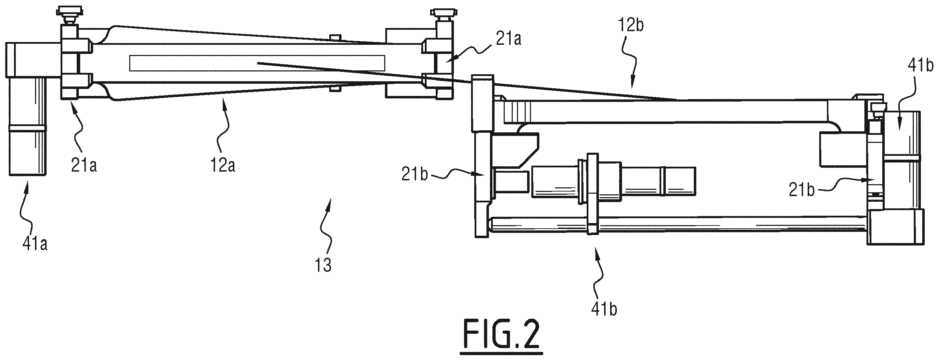

En particulier, une telle installation KB 13 comporte deux supports 21a, 21b visibles notamment sur la figure 2.

Ainsi, comme cela est visible sur cette figure 2, le support 21a permet de supporter le premier miroir 12a et le support 21b permet de supporter le deuxième miroir 12b.

Plus particulièrement, dans l'exemple des figures 1 et 2, chaque support 21a, 21b comprend deux parties disposées sur chaque extrémité du miroir 12a, 12b correspondant. Chacune de ces parties se présente par exemple sous la forme d'une platine avec des moyens de fixation adaptés pour fixer l'extrémité correspondante du miroir 12a, 12b correspondant. Chaque platine est disposée par exemple sensiblement perpendiculairement à la surface réfléchissante 14a, 14b correspondante.

Les supports 21a, 21b sont adaptés pour supporter les miroirs 12a, 12b l'un à la suite de l'autre pour former un chemin de propagation du rayonnement issu de la source jusqu'à la cible selon un angle rasant par rapport à la surface réfléchissante 14a, 14b de chacun de ces miroirs 12a, 12b.

Un tel chemin de propagation est désigné par la référence 25 et est notamment visible sur la figure 1. Dans l'exemple des figures 1 et 2, le chemin de propagation 25 est formé de gauche à droite. Autrement dit, le sens de propagation du rayonnement dans l'exemple de ces figures est de gauche à droite.

Par angle rasant, on entend un angle par rapport à la surface réfléchissante correspondante inférieur à quelques degrés, par exemple inférieur à 2° ou inférieur à 1°.

Dans l'exemple de la figure 1, les supports 21a, 21b de l'installation KB 13 sont perpendiculaires l'un par rapport à l'autre de sorte que la surface réfléchissante 14a du premier miroir 12a est tournée par rapport à la surface réfléchissante 14b du deuxième miroir 12b sensiblement à 90°.

Dans un exemple particulier de l'invention, les deux supports 21a, 21b sont fixes. Ainsi, selon cet exemple, les miroirs 12a, 12b se trouvent solidaires dans l'installation KB 13.

Selon un autre exemple de réalisation, au moins l'un des supports, avantageusement les deux supports 21a, 21b sont mobiles.

En particulier, dans un tel exemple de réalisation, l'un de ces supports ou chacun de ces supports 21a, 21b est monté sur un mécanisme de positionnement (non illustré sur les figures 1 et 2).

Ce mécanisme de positionnement permet par exemple de générer un mouvement en translation du support 21a, 21b correspondant selon au moins un axe et/ou un mouvement en rotation de ce support autour au moins d'un axe.

Avantageusement, selon l'invention, chaque mécanisme de positionnement permet de générer un mouvement en translation du support correspondant selon trois axes et en rotation de ce support autour de trois axes.

Ainsi, dans cet exemple, chacun des supports 21a, 21b est monté sur un mécanisme de positionnement avec six degrés de liberté.

Les deux miroirs 12a, 12b sont par exemple sensiblement identiques.

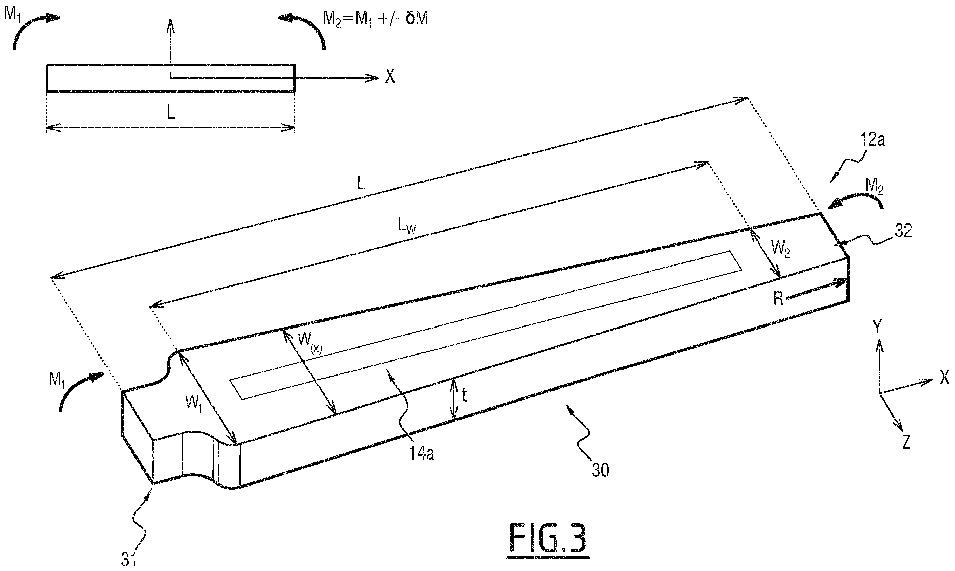

Ainsi, par la suite, seul le miroir 12a sera décrit en détail, notamment en référence à la figure 3.

Comme cela est visible sur cette figure 3, ce miroir 12a présente une forme allongée selon un axe principal, dénoté ci-après comme axe X. La longueur L de ce miroir 12a est définie le long de l'axe principal X.

Deux autres axes perpendiculaires à l'axe principal X sont par ailleurs définis dans l'exemple de cette figure 3. En particulier, la largeur $W(x)$ du miroir 12a s'étend selon l'axe Z et son épaisseur t s'étend selon l'axe Y.

Par ailleurs, comme cela est également visible sur la figure 3, la direction de l'axe principal X correspond sensiblement au sens de propagation R du rayonnement.

L'épaisseur t du miroir 12a est par exemple sensiblement constante. Selon un autre exemple de réalisation (non-expliqué en détail), l'épaisseur t(x) varie le long de l'axe principal X selon la même loi $W(x)$ que la largeur, comme cela est expliqué ci-dessous. Dans ce cas, la largeur du miroir est par exemple sensiblement constante.

Dans l'exemple représenté, le miroir 12a présente une partie utile 30, et une première et une deuxième extrémités de fixation 31, 32 disposées de part et d'autre de la partie utile 30.

La partie utile 30 est utilisable pour réfléchir le rayonnement alors que les extrémités de fixation 31, 32 sont utilisables pour fixer et/ou fléchir le miroir 12 a comme cela sera expliqué par la suite.

La longueur de la partie utile 30, dénotée sur la figure 3 par la référence $L_w$, est donc inférieure à la longueur L du miroir 12a.

Selon l'invention, la largeur $W(x)$ incluant la partie utile 30 est choisie en fonction d'une plage de distances focales prédéterminée pour laquelle le système optique 10 est utilisable.

En particulier, selon le premier exemple de réalisation, le système optique 10 est utilisable pour une plage de distances focales prédéterminée dans laquelle chaque distance focale est supérieure à la longueur du miroir L et inférieure ou égale à un seuil prédéterminé.

Ce seuil prédéterminé est par exemple entre un et dix fois supérieur, avantageusement quinze fois supérieur et encore plus avantageusement vingt fois supérieur à la longueur du miroir L.

Autrement dit, cette plage de distances focales comprend des distances focales supérieures à la longueur L du miroir 12a mais non « très supérieures » à cette longueur. La notion de « très supérieures » peut être aisément définie par l'homme du métier en fonction de chaque application concrète du système optique 10. Cette notion est par ailleurs caractérisée ci-dessus par ledit seuil prédéterminé.

Pour cette plage de distances focales, la largeur $W(x)$ de la partie utile 30 du miroir 12a est variable et est non linéairement décroissante selon le sens de propagation du rayonnement ou autrement dit, selon l'axe principal X.

La largeur $W(x)$ de la partie utile 30 présente donc une fonction de la coordonnée x de l'axe principal X. Cette fonction $W(x)$ peut être approximée par un polynôme dont le plus petit ordre est un. Autrement dit :

$$W(x) \sim \sum_{n \geq 0} a_n x^{2n+1}$$

Dans un tel cas, la largeur $W_1$ de l'extrémité de la partie utile 30 adjacente à la première extrémité de fixation 31 est donc supérieure à la largeur $W_2$ de l'extrémité de la partie utile 30 adjacente à la deuxième extrémité de fixation 32.

Enfin, cette fonction $W(x)$ est choisie de sorte que la surface réfléchissante 14a présente une symétrie par rapport à l'axe principal X.

Selon l'invention, pour ajuster la distance focale dans la plage de distances focales prédéterminée alors par la largeur $W(x)$ des miroirs 12a, 12b, le système optique 10 comprend en outre un mécanisme de déformation 41a, 41b pour chacun des miroirs 12a, 12b.

Ces mécanismes de déformation 41a, 41b sont notamment visibles sur les figures 1 et 2 et permettent de générer une courbure du miroir 12a, 12b correspondant suivant la longueur de ce miroir 12a, 12b. Avantageusement, la courbure générée par ces mécanismes est elliptique.

Pour ce faire, chacun des mécanismes de déformation 41a, 41b est apte à générer un moment fléchissant sur chaque extrémité 31, 32 de fixation du miroir 12a, 12b correspondant.

Tout comme les miroirs 12a, 12b, ces mécanismes de déformation 41a, 41b sont par exemple sensiblement analogues.

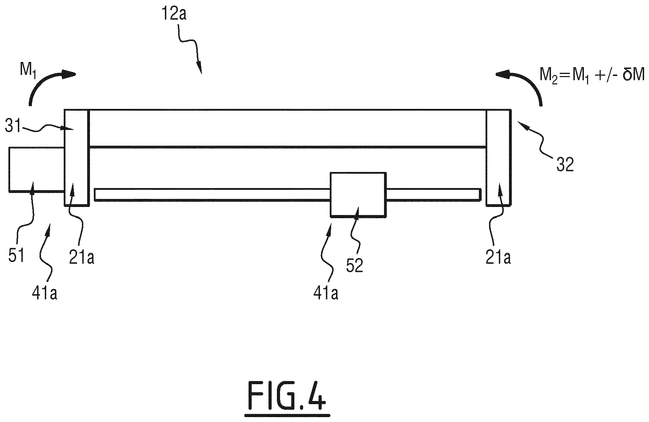

Ainsi, par la suite, seul le mécanisme de déformation 41a sera décrit plus en détail en référence notamment à la figure 4.

En référence à cette figure ainsi qu'à la figure 1, selon le premier mode de réalisation de l'invention, le mécanisme de déformation 41a comprend un actionneur principal 51 et un actionneur auxiliaire 52.

Ces actionneurs 51, 52 sont associés aux extrémités de fixation 31, 32 du miroir 12a et permettent de générer sur chaque extrémité 31, 32 un moment fléchissant respectivement $M_1$, $M_2$.

Pour ce faire, dans l'exemple des figures 1, 2 et 4, l'actionneur principal 51 est apte à exercer un effort sur la partie du support 21a associée à l'extrémité 31 du miroir 12a. En particulier, lorsque cette partie du support 21a se présente sous la forme d'une platine, c'est-à-dire lorsqu'elle présente un profil en « I », l'actionneur 51 est apte à exercer un effort sur cette platine afin de courber le miroir 12a.

L'actionneur auxiliaire 52 est apte à exercer un effort selon l'axe principal X sur chaque partie du support 21a afin de corriger la courbure du miroir 12a engendrée par l'actionneur principal 51.

En particulier, lorsque chaque partie du support 21a se présente sous la forme d'une platine, l'actionneur auxiliaire 52 est apte à écarter l'une de l'autre les extrémités des platines opposées aux extrémités fixant le miroir 12a.

Par ailleurs, comme cela est visible sur la figure 4, l'actionneur auxiliaire 52 est disposé selon l'axe principal de manière dissymétrique par rapport au centre du miroir 12a.

Ainsi disposés, les actionneurs 51, 52 sont aptes à générer des moments fléchissants $M_1$, $M_2$ légèrement différents l'un de l'autre.

Dans l'exemple de la figure 4, le moment fléchissant $M_2$ est égal au moment $M_1$ plus ou moins $\delta M$, où $\delta M$ est une petite valeur par rapport à la valeur $M_1$.

Selon un exemple avantageux du premier mode de réalisation de l'invention, chaque miroir 12a, 12b présente une courbure initiale préformée. Cette courbure est donnée par la forme initiale du substrat du miroir. La forme de cette courbure correspond par exemple à la forme d'une ellipse correspondant au plus grand rayon de courbure atteint par les mécanismes de déformation 41a, 41b correspondants.

En outre, selon un exemple avantageux de l'invention, le système optique 10 comprend un module de contrôle 60.

Ce module de contrôle 60 permet de commander simultanément les mécanismes de déformation 41a, 41b et éventuellement, les mécanismes de positionnement des supports 21a, 21b de l'installation KB 13, afin d'ajuster de manière automatique la distance focale.

Pour se faire, le module du contrôle 60 comprend par exemple une table de correspondance entre différentes distances focales et des paramètres de courbure et éventuellement, des positions des miroirs 12a, 12b.

Ce module de contrôle 60 peut par exemple être actionné par une commande unique par un utilisateur et présente de ce fait une fonction d'autofocus du système 10.

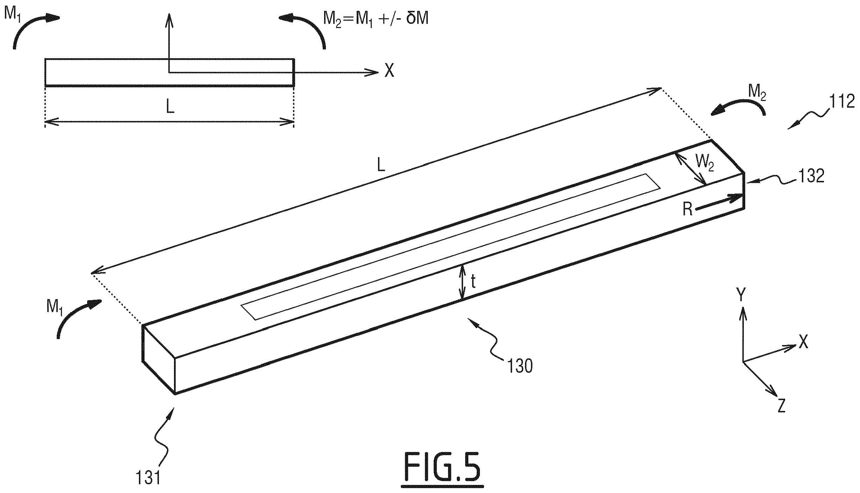

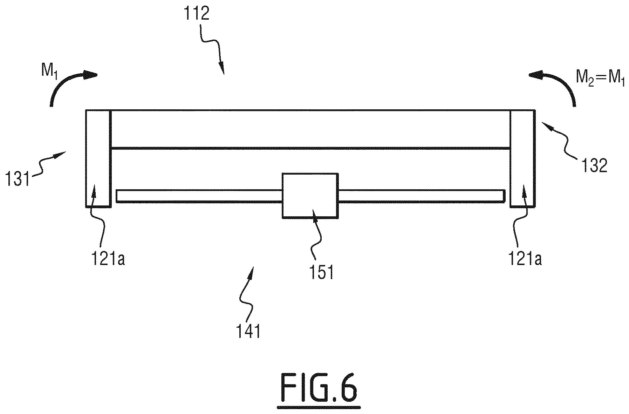

Un système optique selon un deuxième mode de réalisation sera désormais expliqué en référence aux figures 5 et 6.

En particulier, le système optique selon ce mode de réalisation est sensiblement identique au système optique 10 expliqué précédemment et comprend notamment la même installation KB qui ne sera donc pas décrite en détail par la suite.

La seule différence du système optique selon le deuxième mode de réalisation consiste en la forme des miroirs 12a, 12b utilisables dans l'installation KB 13.

Ainsi, comme dans le cas précédent, le système optique selon le deuxième mode de réalisation comprend deux miroirs sensiblement identiques 112, un seul d'entre eux sera expliqué en référence aux figures 5 et 6.

Tout comme dans le cas précédent, le miroir 112 de la figure 5 est de forme allongée selon l'axe principal X. Sa longueur L est définie selon cet axe X et sa largeur et épaisseur sont définies selon respectivement les axes Z et Y, perpendiculaires à l'axe X.

Le miroir 112 présente également une partie principale 130 et deux extrémités 131, 132 de part et d'autre de cette partie principale 130.

Contrairement au mode de réalisation précédent, la partie utile 130 de ce miroir 112 présente une largeur $W$ sensiblement constante.

Selon un premier exemple de ce mode de réalisation, qui n'est pas couvert par la revendication 1, le miroir 112 présente également une épaisseur t constante. Dans ce cas, le système optique est utilisé dans une plage de distances focales prédéterminée dont chaque distance focale est supérieure ou égale au seuil prédéterminé défini en relation avec le premier mode de réalisation. Le seuil prédéterminé est par exemple dix fois supérieur, avantageusement quinze fois supérieur ou encore plus avantageusement vingt fois supérieur à la longueur L du miroir 112. Cela signifie que le miroir 112 selon le deuxième mode de réalisation de l'invention permet d'assurer les distances focales très supérieures à la longueur du miroir L.

Selon un deuxième exemple de ce deuxième mode de réalisation, cet exemple étant couvert par la revendication 1, le miroir 112 présente une épaisseur t(x) variable le long de l'axe principal X. La loi de cette variation est par exemple la même que la loi de variation de la largeur $W(x)$ expliquée en relation avec le premier ou le deuxième mode de réalisation. Dans ce cas, la plage de distances focales prédéterminée dans laquelle le système optique est utilisable dépend de cette loi.

Par ailleurs, le miroir 112 peut présenter initialement une forme sensiblement plate dans le plan XY ou courbée comme expliqué en relation avec le premier ou le deuxième mode de réalisation.

Comme dans le cas précédent, un mécanisme de déformation 141 est associé au miroir 112 pour ajuster la distance focale du système optique dans la plage prédéterminée.

Ce mécanisme de déformation 141, visible sur la figure 6, est alors apte à générer une courbure de forme elliptique du miroir 112 en générant un moment fléchissant sur chaque extrémité de fixation 131, 132 de ce miroir 112.

Selon ce mode de réalisation, ce mécanisme de déformation 141 présente par exemple un seul actionneur 151 qui est apte alors à exercer un effort dans les deux sens de l'axe principal X pour générer le même moment fléchissant $M_1$, $M_2$ sur chacune de ces extrémités 131, 132.

Comme également dans le cas précédent, cet effort est exercé sur chaque partie du support 121a sur chaque extrémité 131, 132 du miroir 112.

En variante, le mécanisme de déformation 141 présente deux actionneurs, comme dans le cas précédent.

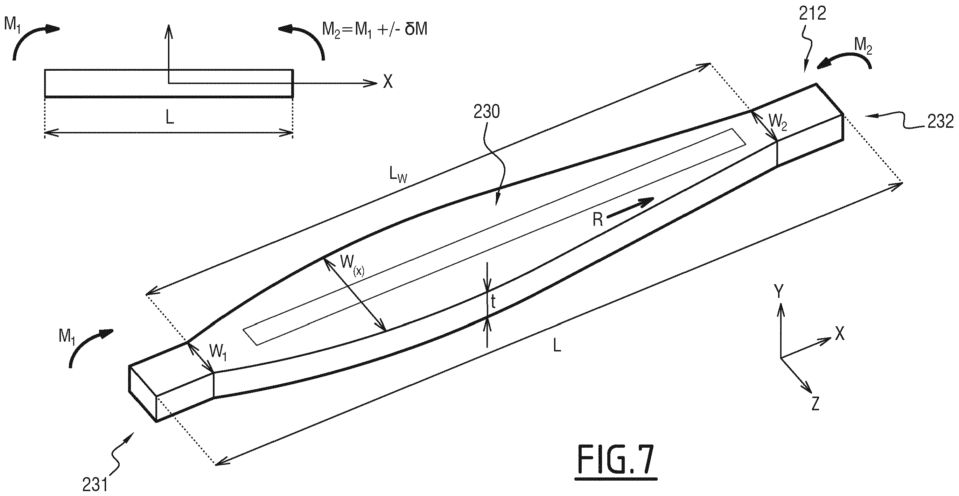

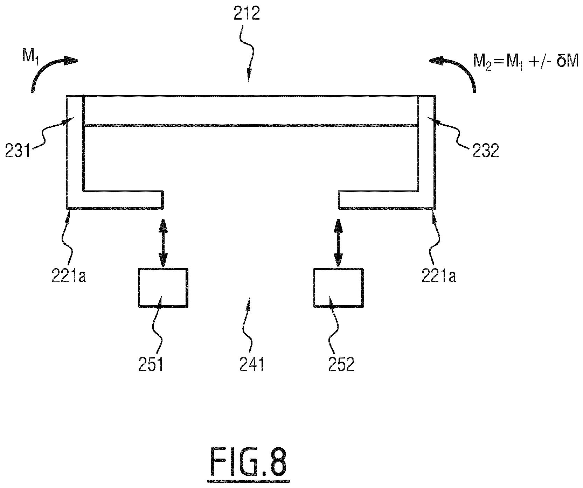

Un système optique selon un troisième mode de réalisation de l'invention sera désormais expliqué en référence aux figures 7 et 8.

Tout comme dans le cas précédent du deuxième mode de réalisation, le système optique selon le troisième mode de réalisation comprend la même installation KB 13 qui ne sera pas décrite par la suite.

La différence de ce système optique selon le troisième mode de réalisation est la forme des miroirs utilisables avec l'installation KB 13 ainsi que le mécanisme de déformation associé.

Également comme dans les cas précédents, ce système optique selon le troisième mode de réalisation comprend deux miroirs 212 sensiblement identiques dont seulement l'un d'entre eux sera décrit par la suite en référence aux figures.

Comme cela est illustré sur la figure 7, comme dans le premier mode de réalisation, le miroir 212 est de longueur L et sa partie principale 230 présente une largeur variable $W(x)$ selon l'axe principal X. L'épaisseur t de ce miroir 212 est par exemple sensiblement constante.

En particulier, cette largeur $W(x)$ est variable non linéairement de manière croissante puis décroissante selon le sens de propagation du rayonnement, c'est-à-dire selon la direction de l'axe principal X.

La largeur $W(x)$ présente donc une fonction de la coordonnée $x$ de l'axe X qui peut être approximée dans ce cas par un polynôme dont le plus petit ordre est égal à deux. Autrement dit :

$$W(x) \sim \sum_{n \geq 1} a_n x^{2n}$$

Ainsi, dans ce cas, la largeur $W_1$ de l'extrémité de la partie principale 230 adjacente à la première extrémité de fixation 231 est sensiblement égale à la largeur $W_2$ de l'extrémité de la partie principale 230 adjacente à la deuxième extrémité 232 de ce miroir 212.

Avec une largeur $W(x)$ ainsi choisie pour les miroirs 212, le système optique selon le troisième mode de réalisation est utilisable pour ajuster la distance focale dans une plage de distances focales prédéterminée dont chaque distance focale est entre L/2 et la longueur du miroir L.

Finalement, tout comme dans les cas précédents, un mécanisme de déformation 241 est associé au miroir 212. Ce mécanisme de déformation 241 est apte à générer une courbure elliptique du miroir 212 suivant sa longueur pour ajuster la distance focale dans ladite plage, en appliquant un moment fléchissant respectivement $M_1$, $M_2$ sur chacune des extrémités 231, 232 de ce miroir.

Selon ce mode de réalisation, le moment fléchissant $M_1$ est significativement différent du moment fléchissant $M_2$.

Par exemple ce moment fléchissant $M_1$ est sensiblement inférieur au moment fléchissant $M_2$.

Pour générer de tels moments, le mécanisme de déformation 241 se présente sous la forme de deux actionneurs 251, 252 qui sont configurés alors pour exercer un effort selon l'axe Y sur chaque partie du support 221a. Dans ce cas, chaque partie du support 221a présente un profil en forme de « L » comme cela est visible sur la figure 8.

Enfin, tout comme dans le premier mode de réalisation, le miroir 212 présente une courbure initiale qui présente une forme elliptique dont le rayon est choisi comme une moyenne arithmétique entre le rayon de courbure correspondant à la focale minimale et celui de la focale maximale.

On conçoit alors que la présente invention présente un certain nombre d'avantages.

Tout d'abord, le système optique selon l'invention permet d'assurer un ajustement de la distance focale dans une plage de distances focales prédéterminée.

Cet ajustement est effectué par les déformations elliptiques des miroirs correspondants.

Par ailleurs, la forme et notamment la largeur de ces miroirs définissent la plage même de ces distances.

Ainsi, le système optique selon l'invention présente une structure simple qui est relativement peu sensible à des imprécisions de fabrication.

En outre, l'homme du métier comprendra que les caractéristiques décrites en référence aux différents modes de réalisation mentionnés ci-dessous, sont combinables entre elles, notamment pour atteindre des plages de distances focales différentes pour le système optique.

Il est également possible de concevoir un ensemble optique comprenant un système optique tel que décrit ci-dessous et une ou plusieurs paires de miroirs interchangeables. Ainsi, pour modifier la plage de distances focales prédéterminée d'un tel système optique, il suffit de changer les miroirs. Par exemple, il est possible de concevoir un tel ensemble avec une paire de miroirs conformes à chacun des modes de réalisation décrits ci-dessus.

**Revendications**

1. Système optique (10) à distance focale variable dans une plage de distances focales prédéterminée, comprenant :

   - deux miroirs (12a, 12b; 112 ; 212), chaque miroir (12a, 12b; 112 ; 212) définissant une surface réfléchissante (14a, 14b) et présentant une longueur s'étendant selon un axe principal (X), une épaisseur s'étendant sensiblement perpendiculairement à l'axe principal (X) et à la surface réfléchissante (14a, 14b), et une largeur s'étendant sensiblement perpendiculairement à la longueur et à l'épaisseur ;
   - une installation mécanique Kirkpatrick-Baez (13) comportant deux supports (21a, 21b ; 121a ; 221a) adaptés pour supporter les miroirs (12a, 12b ; 112 ; 212) l'un à la suite de l'autre selon leur axe principal (X) de sorte à former un chemin de propagation (25) d'un même rayonnement incident selon un angle rasant par rapport à la surface réfléchissante (14a, 14b) de chacun des miroirs ;
le système (10) étant **caractérisé en ce que** chaque miroir (12a, 12b; 112 ; 212) présente une partie utile (30 ; 130 ; 230) dont la largeur et/ou l'épaisseur est(sont) variable(s) et choisie(s) en fonction de ladite plage de distances prédéterminée, et **en ce que**, pour chaque miroir (12a, 12b ; 112 ; 212), il comprend en outre un mécanisme de déformation (41a, 41b ; 141 ; 241) apte à générer une courbure du miroir (12a, 12b ; 112 ; 212) correspondant suivant sa longueur pour ajuster la distance focale dans ladite plage de distances prédéterminée.

2. Système (10) selon la revendication 1, dans lequel chaque miroir (12a, 12b; 112 ; 212) présente en outre deux extrémités de fixation (31, 32 ; 131, 132 ; 231, 232) disposées de part et d'autre de la partie utile (30 ; 130 ; 230) ;
chaque mécanisme de déformation (41a, 41b ; 141 ; 241) étant apte à générer un moment fléchissant sur chaque extrémité de fixation (31, 32 ; 131, 132 ; 231, 232) du miroir (12a, 12b; 112 ; 212) correspondant.

3. Système (10) selon la revendication 2, dans lequel chaque mécanisme de déformation (141) comprend un actionneur unique (151) apte à générer sensiblement un même moment fléchissant sur chaque extrémité de fixation (131, 132) du miroir correspondant (112).

4. Système (10) selon la revendication 2, dans lequel chaque mécanisme de déformation (41a, 41b ; 241) comprend deux actionneurs (51, 52 ; 251, 252), chaque actionneur (51, 52 ; 251, 252) étant apte à générer un moment fléchissant sur au moins l'une des extrémités de fixation (31, 32 ; 231, 232) du miroir (12a, 12b; 212) correspondant.

5. Système (10) selon la revendication 4, dans lequel chaque actionneur (51, 52 ; 251, 252) est apte à générer un moment fléchissant sur l'extrémité ou les extrémités de fixation correspondante(s) :

   - en exerçant un effort selon l'axe principal (X) correspondant sur au moins une partie du support (21a, 21b) ayant un profil en « I » ; ou
   - en exerçant un effort selon un axe perpendiculaire à l'axe principal (X) correspondant au moins une partie du support (221a) ayant un profil en « L ».

6. Système (10) selon l'une quelconque des revendications précédentes, dans lequel la largeur de la partie utile (30 ; 230) de chaque miroir (12a, 12b; 212) est choisie comme suit :

   - variable et non-linéairement décroissante selon le sens de propagation du rayonnement pour une plage de distances prédéterminée dont chaque distance focale est supérieure ou égale à la longueur du miroir correspondant et inférieure ou égale à un seuil prédéterminé, ledit seuil étant dix fois supérieur à la longueur du miroir correspondant ;
   - variable et non-linéairement croissante et puis décroissante selon le sens de propagation du rayonnement pour une plage de distances prédéterminée dont chaque distance focale est inférieure à la longueur du miroir.

7. Système (10) selon l'une quelconque des revendications précédentes, dans lequel pour au moins certaines des plages de distances focales prédéterminée, chaque miroir (12a, 12b; 212) présente une courbure initiale.

8. Système (10) selon l'une quelconque des revendications précédentes, dans lequel la courbure générée par le mécanisme de déformation (41a, 41b ; 141 ; 241) présente une forme elliptique.

9. Système (10) selon l'une quelconque des revendications précédentes, dans lequel chaque support (21a, 21b) de l'installation Kirkpatrick-Baez (13) est montée sur un mécanisme de positionnement apte à générer un mouvement en translation dudit support selon au moins un axe et/ou au un mouvement en rotation dudit support autour au moins d'un axe.

10. Système (10) selon l'une quelconque des revendications 1 à 8, dans lequel chaque support de l'installation Kirkpatrick-Baez (13) est sensiblement immobile.

11. Système (10) selon l'une quelconque des revendications précédentes, comprenant en outre un module de contrôle (60) apte à contrôler le fonctionnement du mécanisme de déformation (41a, 41b ; 141 ; 241) de chaque miroir (12a, 12b; 112 ; 212) selon une configuration prédéterminée.

12. Ensemble optique comprenant :

   - un système optique (10) selon l'une quelconque des revendications précédentes ;
   - au moins deux miroirs interchangeables avec les miroirs dudit système optique (13) pour modifier la plage de distances focales prédéterminées de ce système.

**Patentansprüche**

1. Optisches System (10) mit variabler Brennweite in einem vorbestimmten Abstandsbereich, bestehend aus:

   - zwei Spiegeln (12a, 12b; 112; 212), wobei jeder Spiegel (12a, 12b; 112; 212) eine spiegelnde Oberfläche (14a, 14b) definiert und eine Länge aufweist, die sich nach einer Hauptachse (X) richtet, eine Dicke, die deutlich senkrecht zur Hauptachse (X) und zur spiegelnden Oberfläche (14a, 14b) verläuft, und eine Breite, die deutlich senkrecht zur Länge und zur Dicke verläuft;
   - eine mechanische Kirkpatrick-Baez-Installation (13) mit zwei Trägern (21a, 21b; 121a; 221a), die so angepasst sind, dass sie die Spiegel (12a, 12b; 112; 212) stützen, einer nach dem anderen nach ihrer Hauptachse (X), so dass sie einen Ausbreitungskanal (25) für eine ankommende Strahlung in einem Streifwinkel bezüglich der spiegelnden Oberfläche (14a, 14b) jedes der Spiegel bilden;
   das System (10) zeichnet sich dadurch aus, dass jeder Spiegel (12a, 12b; 112; 212) einen Nutzteil (30; 130; 230) aufweist, dessen Breite und/oder Dicke variabel ist (sind) und bezüglich des Bereichs vorbestimmter Entfernungen, ausgewählt wird (werden), wobei es für jeden Spiegel (12a, 12b; 112; 212) außerdem einen Deformationsmechanismus (41a, 41b; 141; 241) umfasst, der dazu geeignet ist, eine Krümmung des Spiegels (12a, 12b; 112; 212) zu erzeugen, die jeweils seiner Länge entspricht, um die Brennweite des Bereichs vorbestimmter Entfernungen anzupassen.

2. System (10) nach Anspruch 1, in dem jeder Spiegel (12a, 12b; 112; 212) außerdem zwei Befestigungselemente (31, 32; 131, 132; 231, 232) aufweist, die auf beiden Seiten des Nutzteils (30; 130; 230) angeordnet sind;
   jeder Deformationsmechanismus (41a, 41b; 141; 241) ist in der Lage, an jedem entsprechenden Befestigungselement (31, 32; 131, 132; 231, 232) des Spiegels (12a, 12b; 112; 212) ein Biegemoment zu erzeugen.

3. System (10) nach Anspruch 2, bei dem jeder Deformationsmechanismus (141) ein einziges Stellglied (151) umfasst, das geeignet ist ein deutlich gleiches Biegemoment an jedem Befestigungselement (131, 132) des entsprechenden Spiegels (112) zu erzeugen.

4. System (10) nach Anspruch 2, bei dem jeder Deformationsmechanismus (41a, 41b; 241) zwei Stellglieder (51, 52; 251, 252) umfasst, wobei jedes Stellglied (51, 52; 251, 252) in der Lage ist, auf mindestens einem der Befestigungselemente (31, 32; 231, 232) des entsprechenden Spiegels (12a, 12b; 212) ein Biegemoment zu erzeugen.

5. System (10) nach Anspruch 4, in dem jedes Stellglied (51, 52; 251, 252) dazu geeignet ist, ein Biegemoment auf dem oder den entsprechenden Befestigungselement(en) zu erzeugen:

   - Durch Ausübung einer Kraft auf die Hauptachse (X), die mindestens einem Teil des Trägers (21a, 21b) mit einem Profil " I " entspricht; oder
   - Durch Ausübung einer Kraft auf eine senkrecht zur Hauptachse (X) verlaufende Achse, die mindestens einem Teil des Trägers (221a) mit einem Profil" L " entspricht.

6. System (10) nach einem der vorangegangenen Ansprüche, bei dem die Größe des Nutzteils (30; 230) jedes Spiegels (12a, 12b; 212) wie folgt gewählt wird:

   - variabel und nicht-linear abnehmend, je nach Ausbreitungsrichtung des Strahls für einen Bereich vorbestimmter Entfernungen, für die jede Brennweite größer oder gleich der Länge des entsprechenden Spiegels und kleiner oder gleich eines vorbestimmten Schwellenwerts ist, welcher zehnmal höher ist als die Länge des entsprechenden Spiegels;
   - variabel und nicht linienförmig ansteigend und dann abnehmend, je nach Ausbreitungsrichtung des Strahls für einen Bereich vorbestimmter Entfernungen, für die jede Brennweite kleiner ist als die Länge des Spiegels.

7. System (10) nach einem der vorangegangenen Ansprüche, bei dem für mindestens einige der festgelegten Brennweitenbereiche jeder Spiegel (12a, 12b; 212) eine Anfangskrümmung aufweist.

8. System (10) nach einem der vorangegangenen Ansprüche, bei dem die durch den Deformationsmechanismus (41a, 41b; 141; 241) erzeugte Krümmung eine elliptische Form aufweist.

9. System (10) nach einem der vorangegangenen Ansprüche, bei dem jeder Träger (21a, 21b) der Kirkpatrick-Baez-Installation (13) auf einem Positioniermechanismus montiert ist, der geeignet ist, eine Translationsbewegung dieses Trägers um mindestens eine Achse und/oder eine Drehbewegung dieses Trägers um mindestens eine Achse zu bewirken.

10. System (10) nach einem der Ansprüche 1 bis 8, bei dem jeder Träger der Kirkpatrick-Baez-Installation (13) spürbar unbeweglich ist.

**11.** System (10) nach einem der vorangegangenen Ansprüche, das außerdem ein Kontrollmodul (60) umfasst, das in der Lage ist, die Funktionsweise des Deformationsmechanismus (41a, 41b; 141; 241) jedes Spiegels (12a, 12b; 112; 212) gemäß einer vorgegebenen Konfiguration zu kontrollieren.

**12.** Optische Baugruppe, umfassend:

- ein optisches System (10) nach einem der vorangegangenen Ansprüche;
- mindestens zwei mit den Spiegeln des optischen Systems (13) austauschbare Spiegel, zur Änderung des für dieses System festgelegten Brennweitenbereichs.

**Claims**

**1.** An optical system (10) with variable focal distance within a predetermined focal distance range, comprising:

- two mirrors (12a, 12b; 112; 212), each mirror (12a, 12b; 112; 212) defining a reflective surface (14a, 14b) and having a length extending along a major axis (X), a thickness extending substantially perpendicular to the major axis (X) and the reflective surface (14a, 14b), and a width extending substantially perpendicular to the length and thickness;
- a Kirkpatrick-Baez mechanical assembly (13) comprising two supports (21a, 21b; 121a; 221a) adapted to support the mirrors (12a, 12b; 112; 212) one after the other along their principal axis (X) so as to form a propagation path (25) of the same incident radiation at a grazing angle with respect to the reflecting surface (14a, 14b) of each of the mirrors;

the system (10) being **characterized in that** each mirror (12a, 12b; 112; 212) has a useful portion (30; 130; 230) whose width and/or thickness is (are) variable and selected according to the said predetermined distance range, and **in that**, for each mirror (12a, 12b; 112; 212), it further comprises a deformation mechanism (41a, 41b; 141; 241) adapted to generate a curvature of the corresponding mirror (12a, 12b; 112; 212) along its length to adjust the focal distance within said predetermined distance range.

**2.** The system (10) according to claim 1, wherein each mirror (12a, 12b; 112; 212) further has two attachment ends (31, 32; 131, 132; 231, 232) arranged on either side of the useful portion (30; 130; 230); each deformation mechanism (41a, 41b; 141; 241) being adapted to generate a bending moment on each attachment end (31, 32; 131, 132; 231, 232) of the corresponding mirror (12a, 12b; 112; 212).

**3.** The system (10) according to claim 2, wherein each deformation mechanism (141) comprises a single actuator (151) adapted to generate substantially the same bending moment on each attachment end (131, 132) of the corresponding mirror (112).

**4.** The system (10) according to claim 2, wherein each deformation mechanism (41a, 41b; 241) comprises two actuators (51, 52; 251, 252), each actuator (51, 52; 251, 252) being adapted to generate a bending moment on at least one of the attachment ends (31, 32; 231, 232) of the corresponding mirror (12a, 12b; 212).

**5.** The system (10) according to claim 4, wherein each actuator (51, 52; 251, 252) is adapted to generate a bending moment on the corresponding attachment end or ends:

- by exerting a force along the corresponding principal axis (X) on at least a portion of the support (21a, 21b) having an "I" profile; or
- by exerting a force along an axis perpendicular to the corresponding principal axis (X) on at least one portion of the support (221a) having an "L" profile.

**6.** The system (10) according to any one of the preceding claims, wherein the width of the useful portion (30; 230) of each mirror (12a, 12b; 212) is selected as follows:

- variable and non-linearly decreasing according to the direction of propagation of the radiation for a predetermined distance range, each focal distance of which is greater than or equal to the length of the corresponding mirror and less than or equal to a predetermined threshold, said threshold being ten times greater than the length of the corresponding mirror;
- variable and non-linearly increasing and then decreasing along the direction of propagation of the radiation for a predetermined distance range each focal distance of which is less than the length of the mirror.

**7.** The system (10) according to any one of the preceding claims, wherein for at least some of the predetermined focal distance ranges, each mirror (12a, 12b; 212) has an initial curvature.

**8.** The system (10) according to any one of the preceding claims, wherein the curvature generated by the deformation mechanism (41a, 41b; 141; 241) has an elliptical shape.

9. The system (10) according to any one of the preceding claims, wherein each support (21a, 21b) of the Kirkpatrick-Baez installation (13) is supported on a positioning mechanism adapted to generate a translational movement of said support along at least one axis and/or a rotational movement of said support about at least one axis.

10. The system (10) according to any one of claims 1 to 8, wherein each support of the Kirkpatrick-Baez installation (13) is substantially stationary.

11. The system (10) according to any one of the preceding claims, further comprising a control module (60) adapted to control the operation of the deformation mechanism (41a, 41b; 141; 241) of each mirror (12a, 12b; 112; 212) according to a predetermined configuration.

12. An optical assembly comprising:

- an optical system (10) according to any of the preceding claims;
- at least two mirrors interchangeable with the mirrors of said optical system (13) to change the predetermined focal distance range of said system.

FIG.1

EP 3 913 418 B1

FIG.2

FIG.3

12a

$M_1$

$M_2 = M_1 +/- \delta M$

31

32

51

21a

41a

52

41a

21a

# FIG.4

FIG.5

$M_2 = M_1 +/- \delta M$

**FIG.6**

**FIG.7**

$M_1$

$212$

$M_2 = M_1 +/- \delta M$

$231$

$232$

$221a$

$221a$

$251$

$241$

$252$

## FIG.8

**RÉFÉRENCES CITÉES DANS LA DESCRIPTION**

**Documents brevets cités dans la description**

- FR 1049576 A